# EUROPEAN PATENT APPLICATION

(11) **EP 4 064 339 A1**
(43) Date of publication of application: **28.09.2022**
(21) Application number: 21214358.0
(22) Date of filing: 14.12.2021
(51) Int. Cl.: H01L 23/495

(54) **SEMICONDUCTOR DEVICE**

(30) Priority: 22.03.2021 JP 2021047247
(71) Applicant: KABUSHIKI KAISHA TOSHIBA, Minato-ku Tokyo 105-0023 (JP); Toshiba Electronic Devices & Storage Corporation, Tokyo 105-0023 (JP)
(72) Inventor: Yamaguchi, Kakeru, Minato-ku, Tokyo, 105-0023 (JP)
(74) Representative: Hoffmann Eitle

(57) **Abstract**

According to one embodiment, a semiconductor device (10) includes a first lead frame (22), a second lead frame (23A; 23B), a semiconductor chip (21), and a conductive member (24A; 24B). The second lead frame is located apart from the first lead frame. The second lead frame includes a first face (F1) and a second face (F2) intersecting with the first face. The semiconductor chip is connected to the first lead frame. The conductive member electrically connects the semiconductor chip and the second lead frame. The conductive member includes a first connection part (31) and a second connection part (25). The first connection part includes a first connection face (26) connected to the first face by a conductive adhesive. The second connection part includes a second connection face (27) connected to the second face by a conductive adhesive.

## Description

### FIELD

Embodiments described herein relate generally to a semiconductor device.

### BACKGROUND

There is a known semiconductor device in which a lead frame and electrodes of a semiconductor chip are electrically connected by, for example, a plate connector. Electrical and mechanical connections are made between the electrodes and the connector, and between the lead frame and the connector by a conductive adhesive such as solder.

A reflow furnace is used in a bonding process for a semiconductor package manufactured by bonding a silicon (Si) chip to a lead frame and a copper (Cu) connector by using a lead solder and sealing them by molding.

The copper connector during the reflow process is sometimes shifted or rotated due to the surface tension of the molten solder. There is a problem that the occurrence of positional deviation equal to or more than a reference value may result in a defective product in terms of the reliability of the solder joint.

### BRIEF DESCRIPTION OF THE DRAWINGS

FIG. 1 is an external front view of a semiconductor device according to a first embodiment;
FIG. 2 is an external side view of the semiconductor device in the first embodiment;
FIG. 3 is an external back view of the semiconductor device in the first embodiment;
FIG. 4 is an external perspective view of the semiconductor device viewed from a bottom face side;
FIG. 5 is an external perspective view of the semiconductor device viewed from a top face side;
FIG. 6 is a front view of the semiconductor device in the first embodiment before molding;
FIG. 7 is a side view of the semiconductor device in the first embodiment before molding;
FIG. 8 is a top view of the semiconductor device in the first embodiment before molding;
FIG. 9 is a back view of the semiconductor device in the first embodiment before molding;
FIG. 10 is a perspective view from the bottom face side of the semiconductor device in the first embodiment before molding;
FIG. 11 is a perspective view from the top face side of the semiconductor device in the first embodiment before molding;
FIGS. 12A and 12B are diagrams for describing a problem of a conventional semiconductor device before molding;
FIG. 13 is a back view of a metal connector in the first embodiment;
FIG. 14 is a side view of the metal connector in the first embodiment; and
FIGS. 15A and 15B are diagrams for describing a semiconductor device according to a second embodiment.

### DETAILED DESCRIPTION

According to one embodiment, a semiconductor device includes a first lead frame, a second lead frame, a semiconductor chip, and a conductive member. The second lead frame is located apart from the first lead frame. The second lead frame includes a first face and a second face intersecting with the first face. The semiconductor chip is connected to the first lead frame. The conductive member electrically connects the semiconductor chip and the second lead frame. The conductive member includes a first connection part and a second connection part. The first connection part includes a first connection face connected to the first face by a conductive adhesive. The second connection part includes a second connection face connected to the second face by a conductive adhesive.

Next, embodiments will be described with reference to the accompanying drawings.

### First Embodiment

A first embodiment will be described. Note that structural elements according to the embodiments and description thereof may be expressed in a plural forms herein. The structural elements and the description thereof are presented by way of example only, and are not intended to limit the scope of the inventions. The structural elements may be specified by the names different from those used herein. Furthermore, the structural elements may be described in different expressions from those used herein.

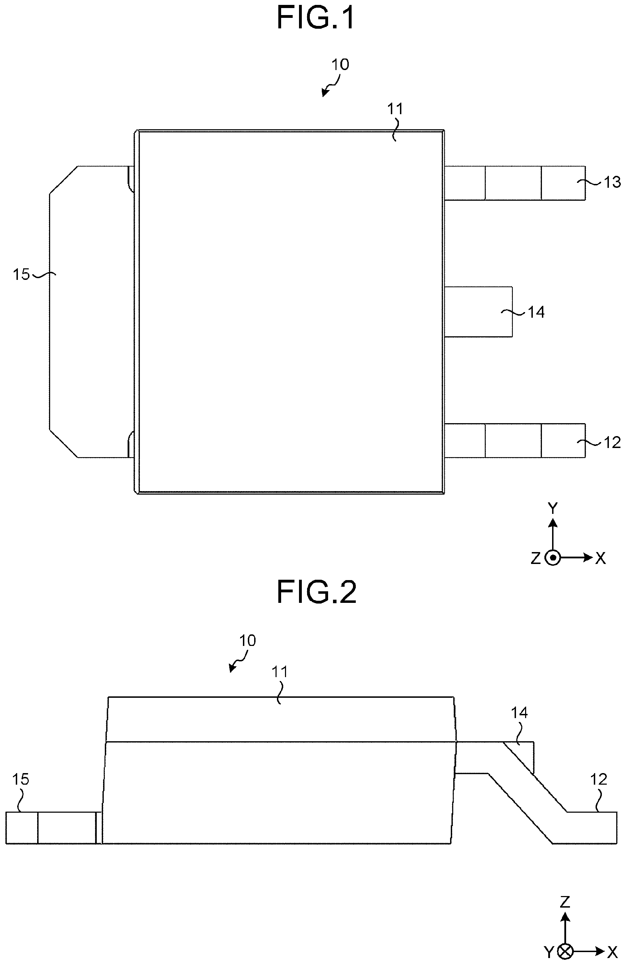

FIG. 1 is an external front view of a semiconductor device according to the first embodiment. FIG. 2 is an external side view of the semiconductor device in the first embodiment. A semiconductor device 10 is assembled as a power device (power transistor), for example. Note that the semiconductor device 10 is not limited to such an example but may also be assembled as another device.

As indicated in each of the drawings, an X-axis, a Y-axis, and a Z-axis are defined in the present description for convenience. The X-axis, the Y-axis, and the Z-axis are orthogonal to each other. The X-axis is set along the width of a semiconductor device 10. The Y-axis is set along the length (or depth) of the semiconductor device 10. The Z-axis is set along the thickness of the semiconductor device 10.

Additionally, an X direction, a Y direction, and a Z direction are defined. The X direction is a direction along the X-axis, and includes a +X direction indicated by an arrow of the X-axis and a -X direction being an opposite direction of the arrow of the X-axis. The Y direction is a direction along the Y-axis, and includes a +Y direction indicated by an arrow of the Y-axis and a -Y direction being an opposite direction of the arrow of the Y-axis. The Z direction is a direction along the Z-axis, and includes a +Z direction indicated by an arrow of the Z-axis and a -Z direction being an opposite direction of the arrow of the Z-axis.

As illustrated in FIG. 1, the semiconductor device 10 includes a resin mold 11, a first connector 12, a second connector 13, a third connector 14, and a fourth connector 15.

In the above-described configuration, the resin mold 11 seals parts of the first connector 12 to the fourth connector 15, and a semiconductor chip, part of a first lead frame, a second lead frame, and a third lead frame, which will be described later.

The first connector 12 and the second connector 13 function as the second lead frame. The third connector 14 and the fourth connector 15 constitute part of the first lead frame. The first connector 12 is provided to extend in the +X direction from the resin mold 11, then extend in the +X direction and the -Z direction gradually, and finally extend in the +X direction. As in the first connector 12, the second connector 13 is provided to extend in the +X direction from the resin mold 11, then extend in the +X direction and the -Z direction gradually, and finally extend in the +X direction. The third connector 14 is provided to extend in the +X direction from the resin mold 11. The fourth connector 15 is provided to extend in the -X direction from the resin mold 11.

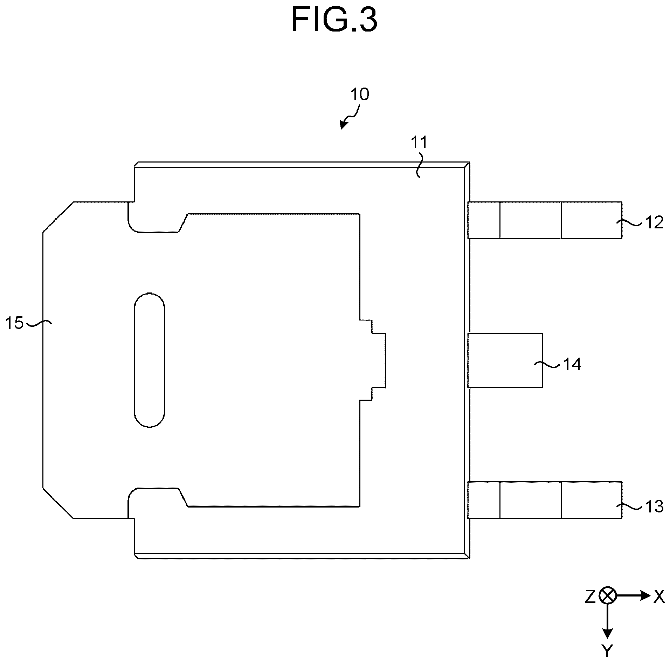

FIG. 3 is an external back view of the semiconductor device in the first embodiment. The fourth connector 15 functions as the lead frame as described above. As illustrated in FIG. 3, the fourth connector 15 is exposed from the resin mold 11 for heat dissipation of a semiconductor chip as described later.

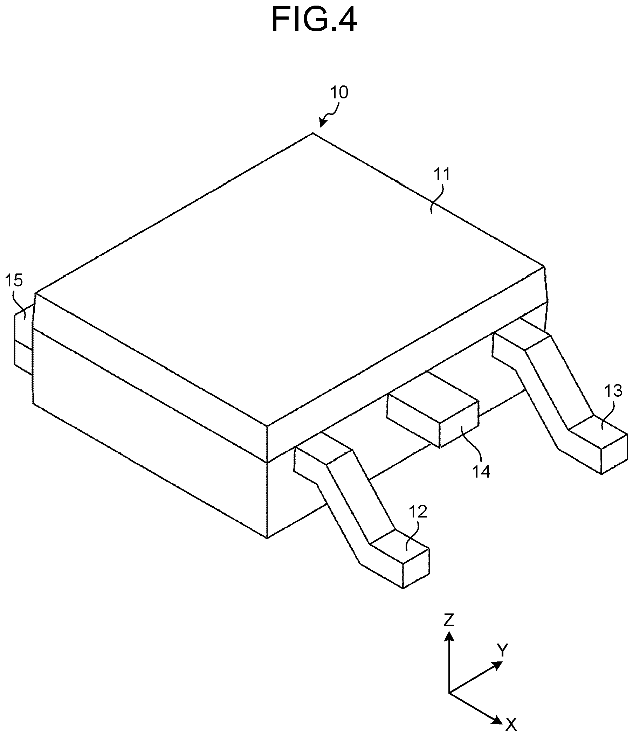

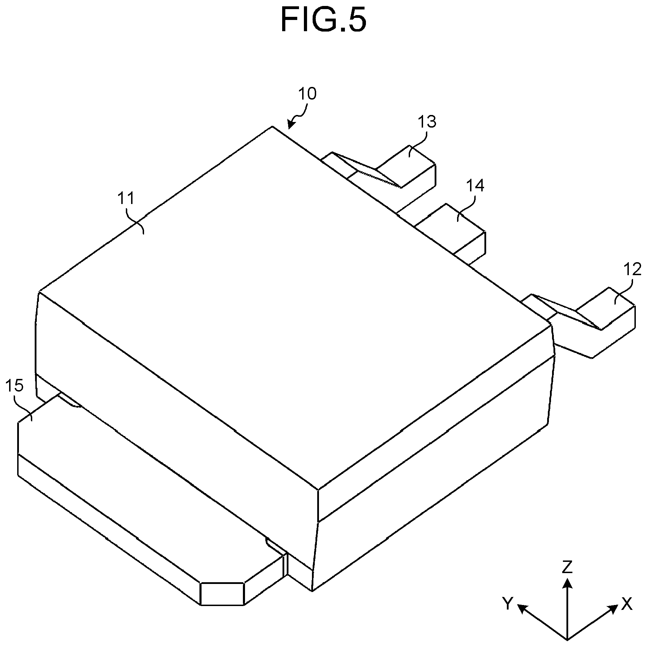

FIG. 4 is an external perspective view of the semiconductor device viewed from a bottom face side. FIG. 5 is an external perspective view of the semiconductor device viewed from a top face side. As illustrated in FIG. 5, the fourth connector 15 is provided to protrude from the top face side (-X direction side) of the resin mold 11. As illustrated in FIG. 4, the first connector 12, the second connector 13, and the third connector 14 protrude from the bottom face side (+X direction side) of the resin mold 11. In this case, the semiconductor device 10 is a surface mount type, so that tips of the first connector 12, the second connector 13, and the third connector 14 are designed such that their faces to be bonded (end faces in the -Z direction) are effectively located on the same X-Y plane.

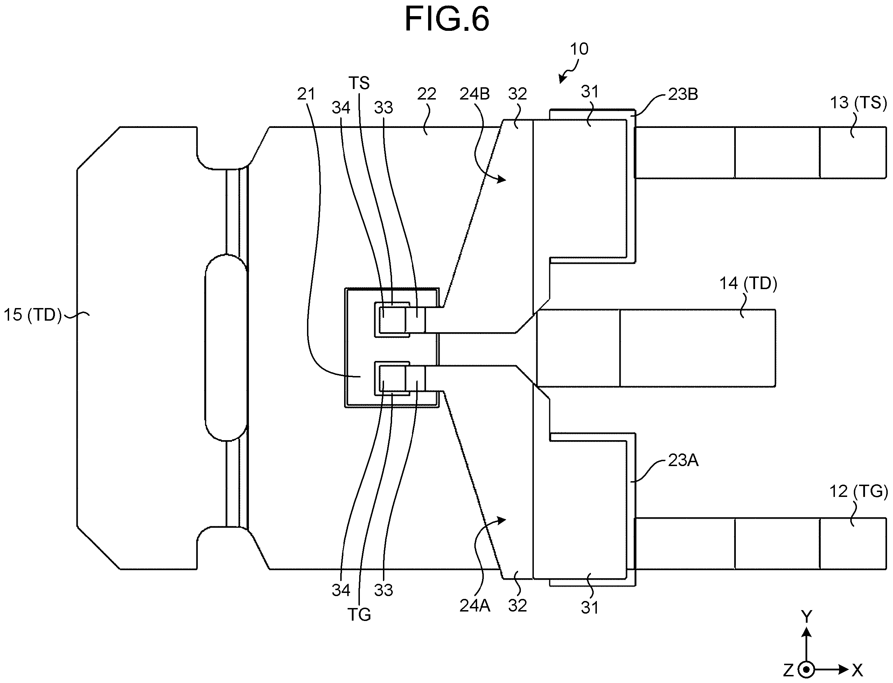

FIG. 6 is a front view of the semiconductor device in the first embodiment before molding. The semiconductor device 10 includes a first lead frame 22 on which a semiconductor chip 21 is installed.

In this case, a gate terminal TG and a source terminal TS are provided on a surface of the front face side (+Z direction side) of the semiconductor chip 21. On a back side of the semiconductor chip 21, a drain terminal is provided although not illustrated. The drain terminal of the semiconductor chip 21 is electrically connected to the first lead frame 22 by a lead solder serving as a conductive adhesive.

As a result, the semiconductor chip 21 is mechanically fixed to the first lead frame 22 and thereby becomes a prescribed heat conductive state. This enables the semiconductor chip 21 to dissipate the heat thereof through the first lead frame 22.

One end (a right end in the case of FIG. 6) of the first lead frame 22 constitutes the third connector 14 functioning as the drain terminal TD. Similarly, the other end (a left end in the case of FIG. 6) of the first lead frame 22 constitutes the fourth connector 15 functioning as the drain terminal TD.

A metal (Cu) connector 24A functioning as a conductive member is electrically connected to the gate terminal TG of the semiconductor chip 21 by a lead solder serving as a conductive adhesive. Similarly, a metal (Cu) connector 24B functioning as a conductive member is electrically connected to the source terminal TS of the semiconductor chip 21 by a lead solder serving as a conductive adhesive.

In this case, the metal connector 24A and the metal connector 24B have line-symmetrical shapes between them in view of the front face as illustrated in FIG. 6, and comprise the same structural elements.

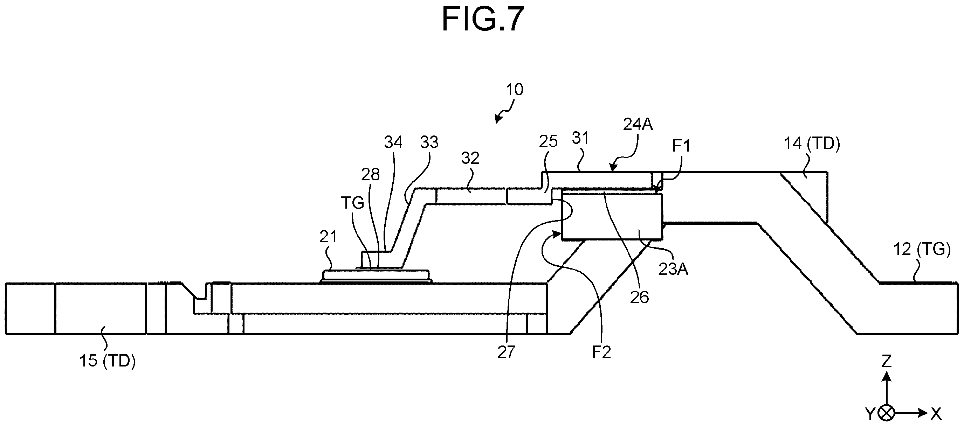

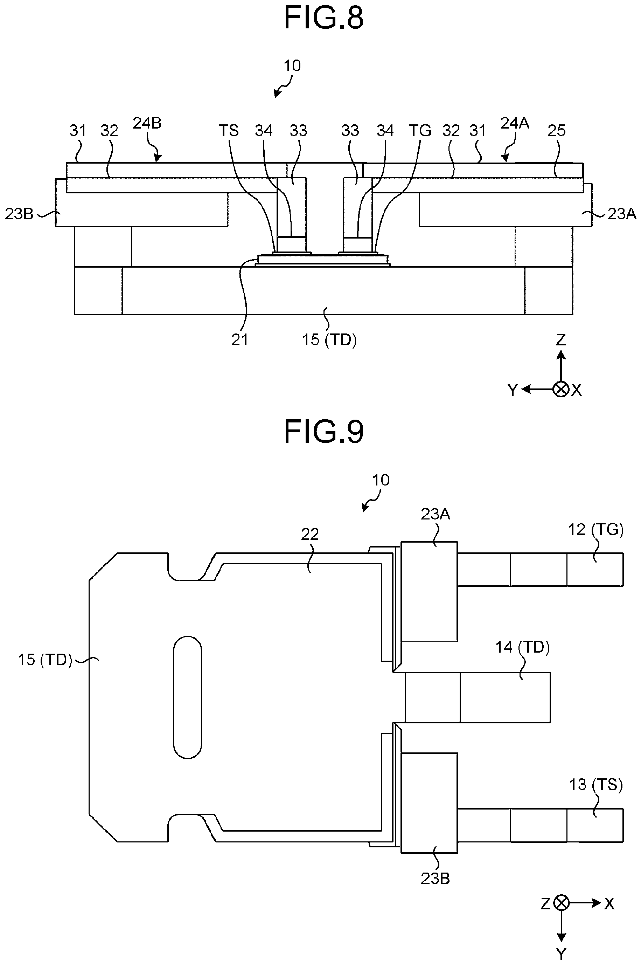

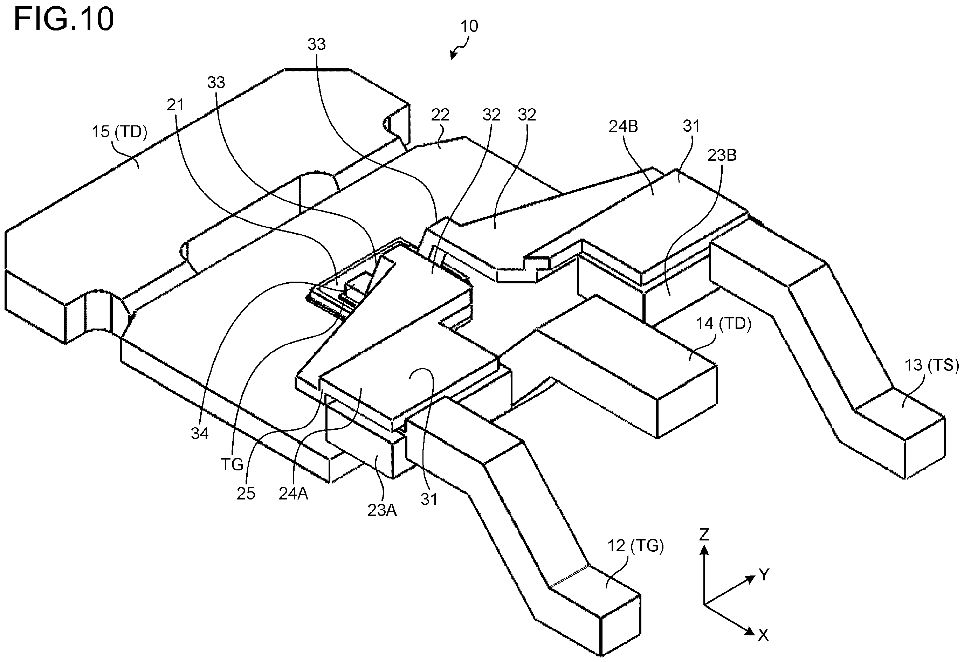

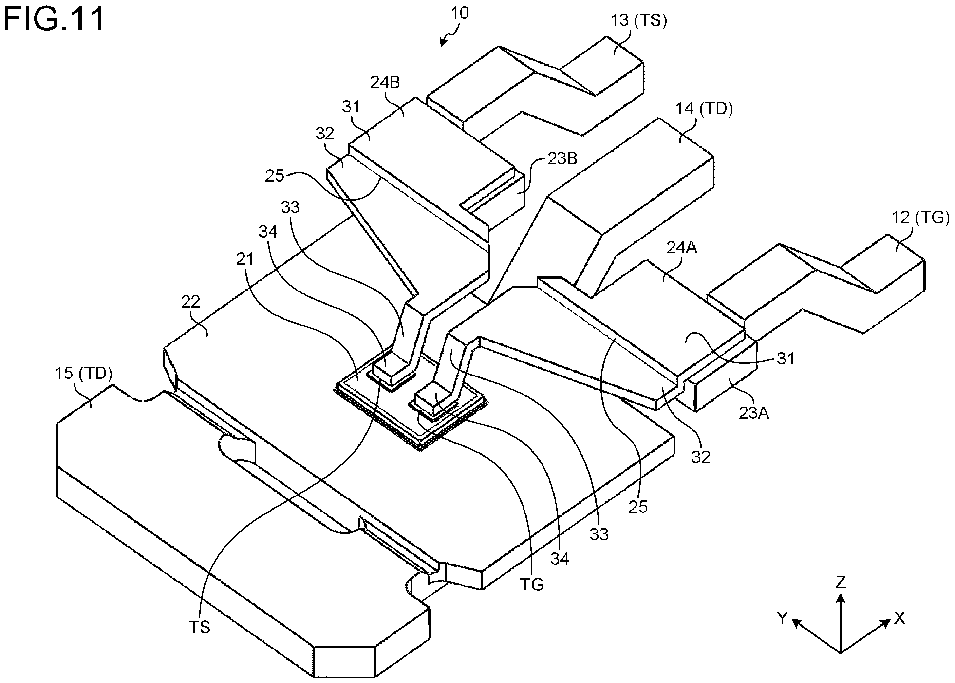

FIG. 7 is a side view of the semiconductor device in the first embodiment before molding. FIG. 8 is a top view of the semiconductor device in the first embodiment before molding. FIG. 9 is a back view of the semiconductor device in the first embodiment before molding. FIG. 10 is a perspective view from the bottom face side of the semiconductor device in the first embodiment before molding. FIG. 11 is a perspective view from the top face side of the semiconductor device in the first embodiment before molding.

As illustrated in FIG. 7 and FIG. 8, the metal connector 24A includes a connection part 31, an extended part 32, an arm part 33, and a connection part 34, which are arranged in the -X direction toward the position where the gate terminal TG of the semiconductor chip 21 is provided. The metal connector 24A has an approximate sigmoid shape. The connection part 31 has a rectangular shape and includes a first connection face 26 on the back face side (-Z direction). The extended part 32 has an approximate trapezoidal shape as illustrated in FIG. 6. The extended part 32 is connected to the arm part 33 while extending from the connection part 31 in the -X direction and the +Y direction along the X-Y plane and being gradually narrowed.

The extended part 32 has a plate shape approximately parallel to the connection part 31 (along the X-Y plane), and is provided at a position shifted in the -Z direction from the connection part 31. Between the connection part 31 and the extended part 32, a bent part 25 formed by, for example, a bending process is provided. The bent part 25 extends in the -Z direction between an edge of the extended part 32 and an edge of the connection part 31.

The arm part 33 is connected to the connection part 34 while gradually extending in the -X direction and the -Z direction so as to reach the gate terminal TG side. The connection part 34 includes, on the back face side (-Z direction side) thereof, a connection face 28 being mechanically and electrically connected to the gate terminal TG.

In the above-described structure, the connection face 28 of the connection part 34 of the metal connector 24A is electrically connected to the gate terminal TG by a lead solder serving as a conductive adhesive. At the back face side (-Z direction side) of the connection part 31, a second lead frame 23A is located. The second lead frame 23A includes a first face F1 and a second face F2 intersecting with the first face F1. The second lead frame is located apart from the first lead frame 22. The first face F1 is an approximate flat face which is directed in the +Z direction, for example. The second face F2 is an approximate flat face which is directed in the -X direction, for example. In this case, the first face F1 is provided along the X-Y plane.

The first connection face 26 of the connection part 31 of the metal connector 24A is mechanically and electrically connected to the first face F1 of the second lead frame 23A by a lead solder serving as a conductive adhesive. The connection part 31 functions as the first connection part. In the metal connector 24A, the bent part 25 as the second connection part including a second connection face 27 is mechanically and electrically connected to the second face F2 of the second lead frame 23A by a lead solder serving as a conductive adhesive. Thereby, the metal connector 24A electrically connects the semiconductor chip 21 and the second lead frame 23A.

In this case, both the second connection face 27 of the metal connector 24A and the second face F2 of the second lead frame 23A extend in the same direction intersecting with the mount face (along the X-Y plane) of the first lead frame 22 where the semiconductor chip 21 is mounted (or connected), that is, the both faces 27 and F2 extend along the Y-Z plane. Additionally, as illustrated in FIG. 7, the second connection face 27 of the metal connector 24A faces at least part of the second face F2 of the second lead frame 23A. Therefore, rotation of the metal connector 24A in a reflow process can be suppressed.

Moreover, the bent part 25 is provided in a manner coupled to the connection part 31 that functions as the first connection part of the metal connector 24A being a conductive member. Therefore, rotation of the metal connector 24A in a reflow process can be suppressed to the minimum. The bent part 25 is provided between the connection part 31, which is the first connection part functioning as a conductive member, and the semiconductor chip 21, so that the bent part 25 works to suppress the positional deviation of the metal connector 24A with respect to the semiconductor chip 21.

Similarly to the metal connector 24A, the metal connector 24B includes a connection part 31, an extended part 32, an arm part 33, and a connection part 34, which are arranged in the -X direction toward the position where the source terminal TS of the semiconductor chip 21 is provided, as illustrated in FIG. 6. The metal connector 24B has an approximate sigmoid shape. The connection part 31 of the metal connector 24B has a rectangular shape and includes a first connection face 26 on the back face side (-Z direction) along the X-Y plane, as in the connection part 31 of the metal connector 24A (FIG. 7). The extended part 32 of the metal connector 24B has an approximate trapezoidal shape as illustrated in FIG. 6, and is connected to the arm part 33 while extending from the connection part 31 in the -X direction and the -Y direction along the X-Y plane and being gradually narrowed.

Similarly to the extended part 32 of the metal connector 24A (FIG. 7), the extended part 32 of the metal connector 24B has a plate shape approximately parallel to the connection part 31 (along the X-Y plane), and is provided at a position shifted in the -Z direction from the connection part 31. Between the connection part 31 and the extended part 32, a bent part 25 formed by, for example, a bending process is provided. The bent part 25 extends in the -Z direction between an edge of the extended part 32 and an edge of the connection part 31.

The arm part 33 of the metal connector 24B is connected to the connection part 34 while gradually extending to the -X direction and the -Z direction so as to reach the source terminal TS side. The connection part 34 of the metal connector 24B includes, on the back face side (-Z direction side) thereof, a connection face 28 being mechanically and electrically connected to the source terminal TS.

In the above-described structure, the connection face 28 of the connection part 34 of the metal connector 24B is electrically connected to the source terminal TS by a lead solder serving as a conductive adhesive. At the back face side (-Z direction side) of the connection part 31, a second lead frame 23B is located. The second lead frame 23B includes a first face F1 and a second face F2 intersecting with the first face F1. The second lead frame 23B is located apart from the first lead frame 22. In this case, the first face F1 is provided along the X-Y plane. The first connection face 26 of the connection part 31 of the metal connector 24B is mechanically and electrically connected to the first face F1 of the second lead frame 23B by a lead solder serving as a conductive adhesive. The connection part 31 functions as the first connection part. In the metal connector 24B, the bent part 25 as the second connection part including the second connection face 27 is mechanically and electrically connected to the second face F2 of the second lead frame 23B by a lead solder serving as a conductive adhesive. Thereby, the metal connector 24B electrically connects the semiconductor chip 21 and the second lead frame 23B.

In this case, both the second connection face 27 of the metal connector 24B and the second face F2 of the second lead frame 23B extend in the same direction intersecting with the mount face (disposed along the X-Y plane) of the first lead frame 22 where the semiconductor chip 21 is mounted (or connected), that is, the both faces 27 and F2 extend along the Y-Z plane. Additionally, the second connection face 27 of the metal connector 24B faces at least part of the second face F2 of the second lead frame 23B. Therefore, rotation of the metal connector 24B in a reflow process can be suppressed.

As illustrated in FIG. 9 to FIG. 11, the first connector 12 is provided in a manner coupled to the second lead frame 23A. Similarly, the second connector 13 is provided in a manner coupled to the second lead frame 23B.

As illustrated in FIG. 9, on the right end and the left end (in the +X direction and in the -X direction) of the first lead frame 22, the third connector 14 and the fourth connector 15 are provided, respectively.

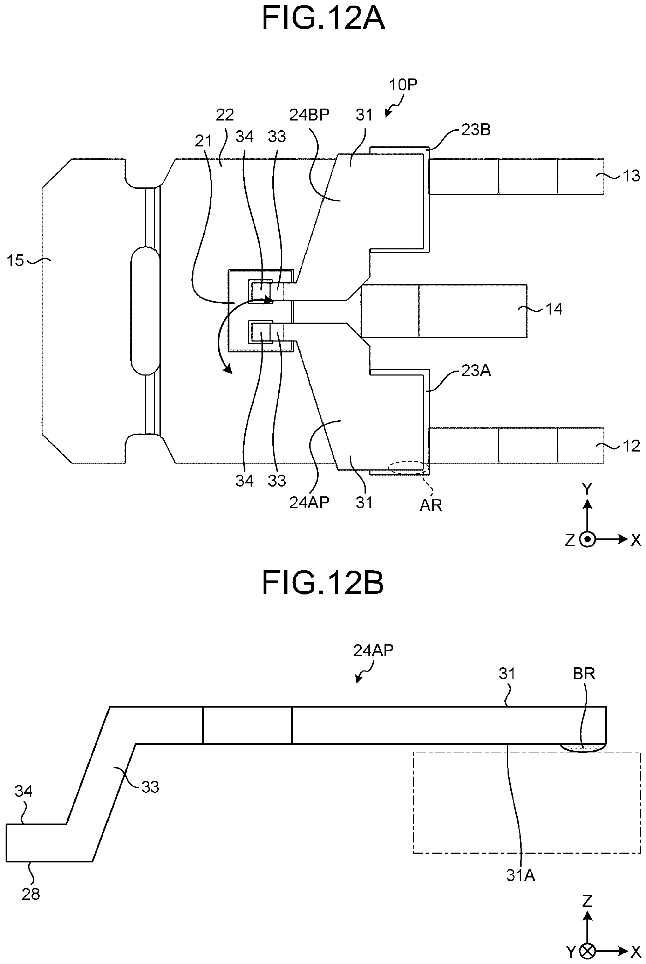

Next, advantages brought by the embodiment will be described. First, a problem in the conventional case will be described. FIGS. 12A and 12B are diagrams for describing a problem of a conventional semiconductor device before molding. In FIGS. 12A and 12B, same reference signs are applied to the same components as those in FIG. 6. FIG. 12A is a front view of the conventional semiconductor device before molding. FIG. 12B is a side view of the conventional semiconductor device before molding.

As illustrated in FIG. 12A, a conventional metal connector 24AP includes a connection part 31, an arm part 33, and a connection part 34. The connection part 31 includes a connection face 31A provided on the back face side thereof. The arm part 33 is provided in a manner coupled to the connection part 31, and extends toward a gate terminal side from the connection part 31. The connection part 34 includes a connection face 28 provided on the back face side thereof.

In the above-described structure, the connection part 34 of the metal connector 24AP is located at a position electrically connected to the gate terminal by a lead solder serving as a conductive adhesive. The connection part 31 includes, on the back face side thereof, a second lead frame 23A having a first face and a second face intersecting with the first face. The second lead frame 23A is located apart from the first lead frame 22.

The connection face 31A of the connection part 31 is located at a position electrically connected to the first face of the second lead frame 23A by a lead solder serving as a conductive adhesive. Here, as to the metal connector 24AP, it is assumed that a burr BR extending downward is generated in an area AR as illustrated in FIG. 12B when punching and bending are performed by the work executed once by a press machine.

Following this state, it is assumed that a reflow process is performed after the metal connector 24AP is disposed, as illustrated in FIG. 12A, on the gate terminal and the second lead frame 23A, which are already applied a lead solder paste for the reflow.

When the lead solder paste comes to a molten state by the reflow process, a moving force or a rotational force is applied to the metal connector 24AP due to the surface tension of the molten lead solder. In a case that the rotational force is applied, the metal connector 24AP may be rotated along the X-Y plane, as indicated with an arrow in FIG. 12A, with respect to the contact part of the burr BR, occurring a positional deviation.

In this case, the occurrence of a positional deviation equal to or more than a reference value can cause, for example, contact of the metal connector 24AP and a metal connector 24BP, which results in having a defective semiconductor device 10P.

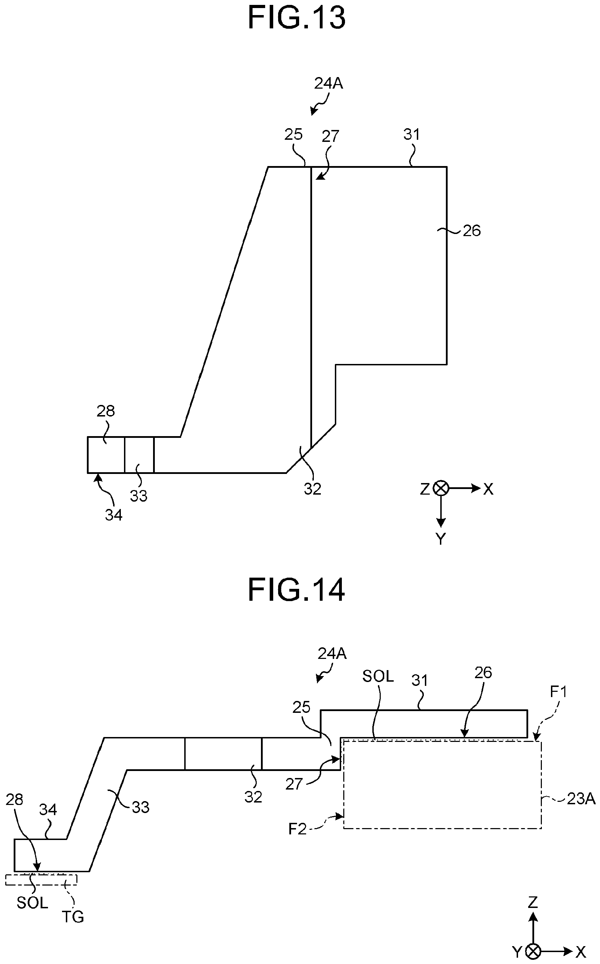

FIG. 13 is a back view of the metal connector in the first embodiment. FIG. 14 is a side view of the metal connector in the first embodiment. Compared to the above-described conventional case, in the metal connector 24A according to the first embodiment described above, the first connection face 26 of the connection part 31 is located at the position facing the first face F1 of the second lead frame 23A, and the second connection face 27 of the bent part 25 is located at the position facing the second face F2 of the second lead frame 23A through a lead solder serving as a conductive adhesive.

When the metal connector 24A as the conductive member is rotated along the connection face (mount face) of the semiconductor chip, the second connection face 27 of the bent part 25 and the second face F2 of the second lead frame 23A directly abut to each other or indirectly abut to each other through the lead solder, thereby restricting the further rotation. The gap distance between the second connection face 27 and the second face F2 is set such that the rotation amount of the metal connector 24A becomes equal to or less than a prescribed allowable value (the positional deviation becomes equal to or less than a prescribed allowable value).

As a result, even if a burr as illustrated in FIG. 12B is formed and the metal connector 24A of the first embodiment is rotated about the burr in the reflow process, the second connection face 27 of the bent part 25 directly abuts to the second face F2 of the second lead frame 23A or indirectly abuts thereto through the lead solder. Therefore, the shift and the rotation of the metal connector 24A can be suppressed.

Moreover, as illustrated in FIG. 14, by the surface tension of the molten solder penetrated between the second connection face 27 of the bent part 25 and the second face F2 of the second lead frame 23A with the capillary action, the second connection face 27 of the metal connector 24A is drawn toward the second face F2 side of the second lead frame 23A to suppress shift and rotation of the metal connector 24A and bonded to a prescribed position by a lead solder SOL serving as a conductive adhesive to be electrically connected.

Along with this, the connection part 34 of the metal connector 24A is electrically connected to a prescribed position of the gate terminal TG by a lead solder serving as a conductive adhesive. This is the same for the metal connector 24B.

As described above, the first embodiment makes it possible to control the behaviors of the metal connector 24A and the metal connector 24B in the reflow process and to suppress deviations of the bonding positions of the metal connectors without changing the manufacture process.

Moreover, as illustrated in FIG. 14, the metal connector 24A is bonded to the second lead frame 23A (the metal connector 24B is bonded to the second lead frame 23B) on the first face F1 and the second face F2 intersecting with each other (orthogonal on the X-Z plane in the case of FIG. 14). Additionally, the bonding is done with a lead solder serving as a conductive adhesive applied in the bent part 25 over the entire width of the second lead frame 23A (23B) (in the top and bottom direction of FIG. 6). Therefore, the crack resistance of the metal connector 24A (24B) can be enhanced.

### Second Embodiment

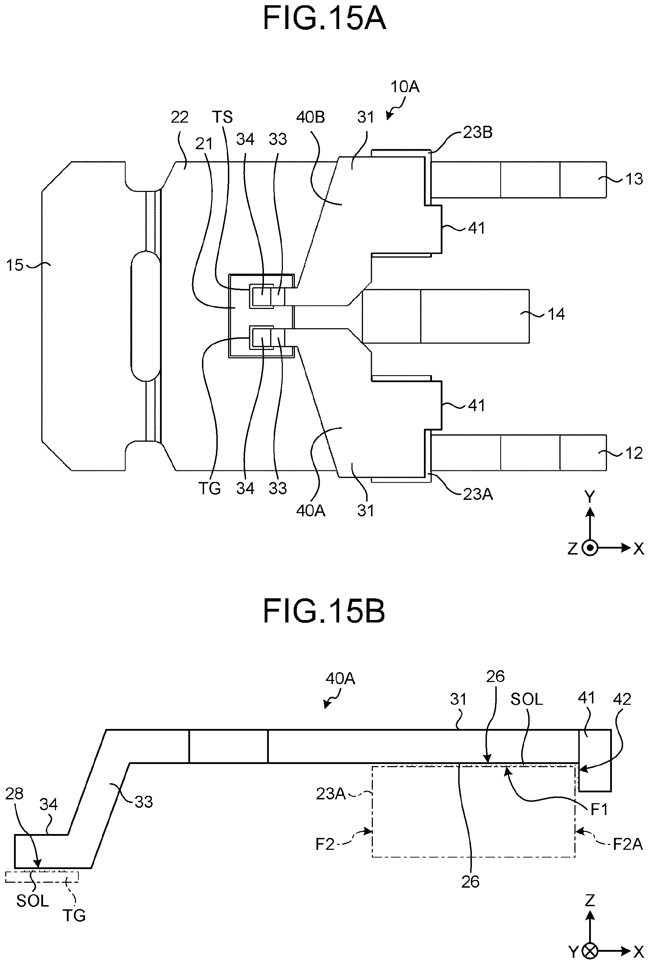

Next, a second embodiment will be described. FIGS. 15A and 15B are diagrams for describing a semiconductor device according to the second embodiment. FIG. 15A is a front view of the semiconductor device before molding. In FIG. 15A, same reference signs are applied to the same components as those in FIG. 6. FIG. 15B is a side view of a metal connector according to the second embodiment.

A semiconductor device 10A includes the first lead frame 22 on which the semiconductor chip 21 is connected (mounted). A metal (Cu) connector 40A functioning as a conductive member is electrically connected to the gate terminal TG of the semiconductor chip 21 by a lead solder serving as a conductive adhesive.

Similarly, a metal (Cu) connector 40B functioning as a conductive member is electrically connected to the source terminal TS of the semiconductor chip 21 by a lead solder serving as a conductive adhesive. In this case, as illustrated in FIG. 15A, the metal connector 40A and the metal connector 40B have line-symmetrical shapes between them, and comprise the same structural elements.

A bent part 41 formed by bending, for example, is provided on an edge of the connection part 31 on the opposite side of the arm part 33. In the second embodiment, the arm part 33 is provided in a manner coupled to the connection part 31, and the extended part 32 between the connection part 31 and the arm part 33 as well as the bent part 25 between the extended part 32 and the connection part 31 are omitted. Note, however, that the extended part 32 and the bent part 25 may be provided to the metal connector 40A and the metal connector 40B in the second embodiment.

The second lead frame 23A and the second lead frame 23B in the second embodiment each include a second face F2A intersecting with the first face F1. The second face F2A is provided on the opposite side of the second face F2 of the first embodiment.

As described above, in the metal connector 40A according to the second embodiment, the first connection face 26 of the connection part 31 as the first connection part is located at the position facing the first face F1 of the second lead frame 23A, and a second connection face 42 of the bent part 41 is located at the position facing the second face F2A of the second lead frame 23A through a lead solder serving as a conductive adhesive. Moreover, the bent part 41 is provided in a manner coupled to the connection part 31 serving as the first connection part of the metal connector 40A functioning as a conductive member. Therefore, rotation of the metal connector 40A in the reflow process can be suppressed to the minimum.

Both of the second connection face 42 of the bent part 41 and the second face F2A of the second lead frame 23A extend in the same direction intersecting with the mount face (along the X-Y plane) of the first lead frame 22 where the semiconductor chip 21 is mounted, that is, the both faces 42 and F2A extend along the Y-Z plane. Additionally, the second connection face 42 of the bent part 41 faces at least part of the second face F2A of the second lead frame 23A. Therefore, rotation of the metal connector 40A in a reflow process can be suppressed.

As a result, even if a burr as illustrated in FIG. 12B is formed and the metal connector 40A of the second embodiment is rotated about the burr during the reflow process, the second connection face 42 of the bent part 41 abuts on the second face F2A of the second lead frame 23A. Therefore, the shift and the rotation of the metal connector 40A can be suppressed.

Moreover, as illustrated in FIG. 15B, by the surface tension of the molten solder entered between the second connection face 42 of the bent part 41 and the second face F2A of the second lead frame 23A by the capillary action, the second connection face 42 of the metal connector 40A is drawn toward the second face F2A side of the second lead frame 23A to suppress shift and rotation of the metal connector 40A and bonded to a prescribed position by the lead solder SOL serving as a conductive adhesive to be electrically connected.

Along with this, the connection part 34 of the metal connector 40A is electrically connected to a prescribed position of the gate terminal TG by a lead solder serving as a conductive adhesive. This is the same for the metal connector 40B.

As described above, the second embodiment makes it possible to control the behaviors of the metal connector 40A and the metal connector 40B in the reflow process and to suppress deviations of the bonding positions of the metal connectors without changing the manufacture process.

Moreover, as illustrated in FIG. 15B, the metal connector 40A is bonded to the second lead frame 23A (the metal connector 40B is bonded to the second lead frame 23B) on the first face F1 and the second face F2A intersecting with each other (orthogonal on the X-Z plane in the case of FIG. 15B). Additionally, the bonding is done with a lead solder serving as a conductive adhesive being applied in the bent part 41 over the entire width (in the +Y direction and the -Y direction indicated in FIG. 15A). Therefore, the crack resistance of the metal connector 40A (40B) can be improved.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor device (10) comprising:
a first lead frame (22);
a second lead frame (23A; 23B) located apart from the first lead frame, the second lead frame including a first face (F1) and a second face (F2) intersecting with the first face;
a semiconductor chip (21) connected to the first lead frame; and
a conductive member (24A; 24B) electrically connecting the semiconductor chip and the second lead frame, the conductive member including a first connection part (31) and a second connection part (25), the first connection part including a first connection face (26) connected to the first face by a conductive adhesive, the second connection part including a second connection face (27) connected to the second face by a conductive adhesive.

2. The semiconductor device according to claim 1, wherein the second connection face (27) of the conductive member and the second face (F2) of the second lead frame extend in a same direction while facing each other, the same direction intersecting with a connection face of the first lead frame where the semiconductor chip is connected.

3. The semiconductor device according to claim 2, wherein, when the conductive member (24A; 24B) is rotated along a connection face of the semiconductor chip, the second connection face (27) of the conductive member and the second face (F2) of the second lead frame restrict a further rotation of the conductive member by directly abutting to each other or indirectly abutting to each other through the conductive adhesive.

4. The semiconductor device according to claim 1 or 2, wherein, in the conductive member (24A; 24B), the second connection part (25) is provided in a manner coupled to the first connection part (31).

5. The semiconductor device according to claim 4, wherein the second connection part (25) is provided between the first connection part (31) and the semiconductor chip (21).
